**Europäisches Patentamt**

**European Patent Office**

**Office européen des brevets**

(19)

(11) Publication number: **0 177 943**
**B1**

(12)                **EUROPEAN PATENT SPECIFICATION**

(45) Date of publication of patent specification: **19.07.89**

(51) Int. Cl.⁴: **H 01 L 23/48,** H 01 L 23/10

(21) Application number: **85112768.8**

(22) Date of filing: **08.10.85**

(54) **Semiconductor device package for high frequencies.**

(30) Priority: **08.10.84 JP 210974/84**

(43) Date of publication of application:
**16.04.86 Bulletin 86/16**

(45) Publication of the grant of the patent:
**19.07.89 Bulletin 89/29**

(84) Designated Contracting States:
**DE FR GB**

(56) References cited:
**EP-A-0 110 997**
**FR-A-2 513 012**
**GB-A-1 492 015**

(73) Proprietor: **FUJITSU LIMITED**
**1015, Kamikodanaka Nakahara-ku**
**Kawasaki-shi Kanagawa 211 (JP)**

(72) Inventor: **Yamamura, Shigeyuki c/o FUJITSU**
**LIMITED**
**Patent Department 1015 Kamikodanaka**
**Nakahara-ku Kawasaki-shi Kanagawa 211 (JP)**

(74) Representative: **Sunderland, James Harry et al**
**HASELTINE LAKE & CO Hazlitt House 28**
**Southampton Buildings Chancery Lane**
**London WC2A 1AT (GB)**

Courier Press, Leamington Spa, England.

## Description

The present invention relates to a semiconductor device package for high frequencies, for example for semiconductor devices used in microwave circuits or high-speed digital circuits.

Solid-state microwave devices such as GaAs-FETs (gallium arsenide Field Effect Transistors) have been used in wide-band amplifiers for communication equipments or booster amplifiers for voltage-controlled oscillators operated in a microwave frequency band ranging from 2GHz to 30 GHz or higher. In the band, packaging design for such GaAs-FETs must be effected on the basis of a concept different from that applicable to transistors or ICs (Integrated Circuit) operated in the relatively low frequency bands, since the dimensions of the package become close to the wavelength of microwave signals. For instance, 3 cm is the wavelength of a microwave signal of 10 GHz.

The inventor has proposed packages for semiconductor devices used in a 2 to 30 GHz band. The proposed packages, which comprise a metallic container for containing a semiconductor device or circuit therein, are intended to solve problems occurring in such high frequency band in previous packages comprising a ceramic container. That is, the ceramic container has undesirable effects which become marked when the semiconductor device or circuit housed therein is operated in a microwave frequency band. For instance, a ring-shaped metallized layer formed on a ceramic container, which is for attaching a lid thereon, would function as a resonator, thereby establishing an apparent oscillation circuit in conjunction with a parasitic capacitance relating to the ceramic container. In a practical package, the oscillation frequency defined by the inductance of the ring-shaped metallized layer and the parasitic capacitance usually matches a microwave frequency in the band, and therefore the effective frequency band allowed for the semiconductor device or circuit is inevitably narrowed. Other kinds of problems relating to such ceramic containers have been described.

The above-mentioned proposed packages comprising a metallic container can be free from problems, including the above-mentioned oscillation effect, involved with a ceramic container. However, different problems arise in connection with insufficient positional accuracy of input/output terminals provided on a package. In the package, the input/output terminals having a strip line each are hermetically sealed to the metallic container in separated relationship under the condition that each of the strip lines is electrically isolated from the metallic container. The terminals are apt to deviate from their respective designed positions on the metallic container, mainly during the process used for hermetic sealing. Poor positional accuracy of the terminal results in an unfavourable bonding between the packages in cascade connection. Such unfavourable bonding includes, for example, an increase in the length of bonding ribbons interconnecting respective corresponding terminals on the cascaded packages, and (the occurrence of) a step between a strip line and a bonding ribbon. These structural failures in bonding become the cause of impedance mismatching, and therefore of degradation of high-frequency characteristics of the circuit comprising the packages. The problems outlined above will be further discussed below with reference to the drawings. In semiconductor device packages known from EP-A-0 110 997 electrical terminal means are engaged in openings provided in a side wall of a metal housing. The electrical terminal means comprises an insulating base, a strip line on the base and an insulating material block member selectively covering a middle portion of the strip line.

An embodiment of the present invention can provide a package for a semiconductor device or circuit operated in a microwave frequency band or such a device or circuit operated to switch high-speed digital signals.

An embodiment of the present invention can provide a package suitable for cascade connection of semiconductor devices or circuits operated in a microwave frequency band or such devices or circuits operated to switch high-speed digital signals.

An embodiment of the present invention provides a package for a semiconductor device or circuit, the package comprising a metallic container and a single electrical terminal means, wherein the metallic container has a metallic base portion and a metallic side wall portion affording a through-hole arrangement formed to engage therein the electrical terminal means secured to the metallic container. The through-hole arrangement has cutout portions successively formed on an edge thereof to leave corresponding tooth portions, consisting of parts of the side wall portion, therebetween. The electrical terminal means includes an insulating material base portion having a surface bonded to the metallic base portion and a plurality of insulating material block members each of which has a surface bonded to a corresponding one of the cutout portions of the through-hole arrangement. The insulating material base has a plurality of strip lines formed thereon in parallel relationship and penetrating the side wall portion perpendicularly. Each of the strip lines has a width in a direction perpendicular to the extension thereof. Each of the insulating material block members has a width larger than the width of the strip lines and a depth substantially equal to the thickness of the side wall and is combined with the insulating material base so as to selectively cover the corresponding one of the strip lines with another surface thereof defined by the width and depth.

Reference is made, by way of example, to the accompanying drawings, in which:

Fig. 1 is a perspective view illustrating a package for a high-frequency semiconductor device or circuit, according to an embodiment of the present invention;

Fig. 2 is a perspective view illustrating an exemplary structure of electrical terminal means 12 as shown in Fig. 1;

Figs. 3 and 4 are perspective views for explaining an exemplary fabrication process for the electrical terminal means 12 shown in Fig. 2;

Fig. 5 is a perspective view illustrating a previously proposed package for a semiconductor device or circuit operated in microwave frequency band;

Fig. 6 is a perspective view for illustrating detailed structure of an electrical terminal means 1 as shown in Fig. 5;

Fig. 7 is a cross-sectional view taken along line Y-Y' in Fig. 5;

Fig. 8 is a plan view illustrating a plurality of packages, each as shown in Fig. 5, in cascade connection;

Fig. 9 is a cross-section taken along line Z-Z' in Fig. 8;

Figs. 10(a) and 10(b) are enlarged plan views respectively illustrating an exemplary positional mismatch between abutting strip lines on previously proposed packages in cascade connection and an obliquely disposed bonding ribbon for interconnecting such mismatched strip lines;

Fig. 11 is a partial plan view illustrating another type of positional deviation of electrical terminal means occurring with previously proposed packages;

Fig. 12 is an exploded perspective view for explaining the assemblage of a metallic container and electrical terminal means according to an embodiment of the present invention;

Figs. 13(a), 13(b) and 13(c) are respectively a plan view, a front view, and a side view of another embodiment of the present invention;

Fig. 13(d) is a cross-sectional view taken along line A-A in Fig. 13(a); and

Fig. 14 is an equivalent circuit diagram of the circuit contained in the package shown in Fig. 13(a).

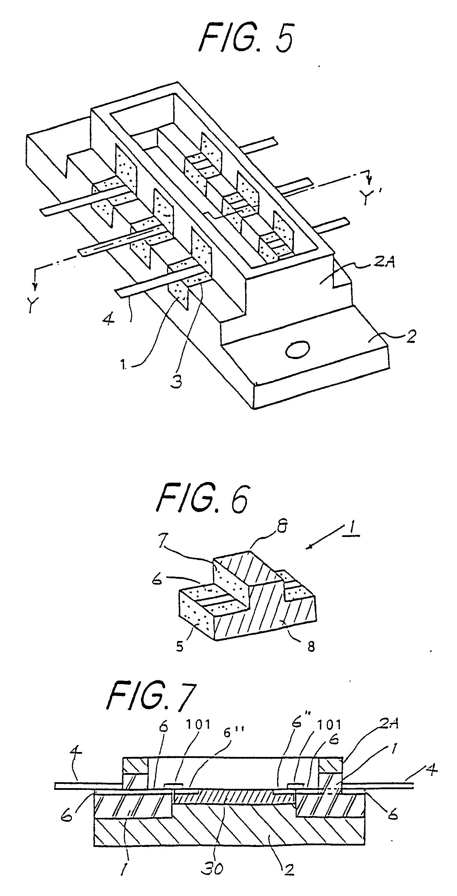

For appreciating better the improvements and advantages afforded by a package embodying the present invention there is first described, with reference to Figs. 5 to 11, a previously proposed package structure (as proposed in the above-mentioned U.S. applications).

Fig. 5 is a perspective view illustrating a previously proposed package for a semiconductor device or circuit operated in microwave frequency band. Referring to Fig. 5, the package comprises electrical terminal means 1, a metallic base portion 2 formed of copper, for instance, the metallic base portion having a side wall portion 2A formed thereon, on or in which three separated through-holes 3 are formed, and lead tabs 4 bonded to corresponding strip lines to be described later. In the package of Fig. 5, three electrical terminal means 1 are provided on each of two opposite side walls of the side wall portion 2A.

Fig. 6 is a perspective view illustrating a detailed structure for one electrical terminal means 1. As shown in Fig. 6, each of the electrical terminal means 1 comprises an insulating material base 5, composed of alumina for example, a strip line 6, of tungsten for example, printed on the upper surface of the insulating material base 5, and an insulating material block member 7, composed of alumina for example, which is disposed on the insulating material base 5 so as to cover the middle portion of the strip line 6. The insulating material base 5 and block member 7 are sintered to form a unified body. Further, a metallized layer 8 is formed to cover respective opposite side surfaces of the insulating material base 5 and block member 7, and the upper surface of the latter, as shown in Fig. 6. The bottom surface of the insulating material base 5 is also coated with the metallized layer.

Such electrical terminal means 1 is engaged in a through-hole 3 and secured to the metallic side wall portion 2A, as typically shown in Fig. 7 which is a cross-sectional view taken along Y-Y' line in Fig. 5. In Fig. 7, like reference signs designate like or corresponding parts to those of Fig. 5. For establishing a hermetically sealed condition, the electrical terminal means 1 and the metallic side wall portion 2A are brazed together with a silver solder, for example. The exposed surface of the strip line 6 is plated with gold (Au) after completion of the brazing process. The lead tabs 4 are for connecting the strip lines 6 to corresponding external wirings (not shown). In Fig. 7, 30 is a semiconductor circuit, such as a balanced amplifier, housed in the package and 6'' designates strip lines formed on the semiconductor device 30, which are connected to corresponding strip lines 6 via bonding leads 101. The package configuration shown in Fig. 5 has advantages as described below.

1) As mentioned above, undesirable oscillation in a microwave frequency band is caused in a package employing a ceramic container, due to the inductance involved with a ring-shaped metallized layer formed on the upper surface of the ceramic container for attaching a lid thereon. However, in the package comprising a metallic container as shown in Fig. 5, such undesirable oscillation is prevented even when a ceramic lid having a metallized layer formed thereon is attached to the metallic container. Hence, desirable frequency characteristics can be obtained.

2) In the package shown in Fig. 5, connection to an external circuit can be performed with strip lines. Since strip line mode wiring is usually employed for the internal circuitry of the package, there is no need for transmission mode conversion between packages connected in cascade relationship using strip lines. This means that high-frequency characteristic degradation due to the discontinuity involved in mode conversion of a transmission signal between packages can be avoided so far as input or output signal lines of a package are wired using strip lines.

3) Further, in the package of Fig. 5, adjacent strip lines 6 are electrically isolated from each other by the metallic side wall portion (2A) which is kept at ground potential. Hence, coupling of the strip lines at high frequency can be prevented.

Exemplary dimensions of the electrical terminal means 1 as shown in Fig. 6 are 1.2 mm for the height from the bottom surface of the insulating material base 5 to the upper surface of the insulating material block member 7, 0.5 mm and 1 mm for the respective lengths of the insulating material block member 7 and base 5 in the direction along the extent of the strip line 6, and 0.3 mm and 1.2 mm for the respective widths of the strip line 6 and the insulating material base 5.

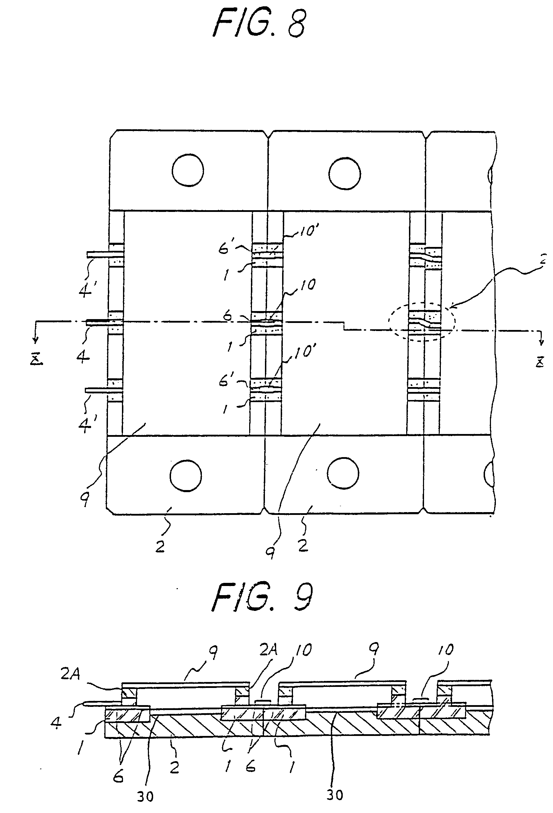

Fig. 8 is a plan view illustrating a plurality of packages connected in a cascade relationship wherein each of the packages has a structure as shown in Fig. 5. Fig. 9 is a cross-sectional view taken along line Z-Z' in Fig. 8. In Figs. 8 and 9, like reference signs designate like or corresponding parts as in the preceding Figures.

Referring to Figs. 8 and 9, each package is provided with a lid 9 attached to the top of the metallic container 2(2A). Corresponding abutting strip lines 6 or 6' of neighbouring packages are interconnected by means of corresponding bonding ribbons 10 or 10', of gold for example, wherein the strip lines 6 and ribbon 10 are those relevant for signal lines whilst the strip lines 6' and ribbon 10' are those relevant for DC voltage supply lines. Lead tabs 4 and 4', which are also relevant to signal lines and DC voltage supply lines, are bonded to the corresponding outer side strip lines 6 and 6' of the outermost package (the left hand side package in Figs. 8 and 9), respectively. A semiconductor device 30, a balanced amplifier, for example, is housed in each of the packages and electrically connected to the strip lines on the electrical terminal means 1 in the same manner as is shown in Fig. 7.

In the cascade connection of packages as shown in Figs. 8 and 9, there is probably a portion as indicated by reference sign 20 in which corresponding strip lines on neighbouring packages do not correctly abut in line with one another. Therefore, the bonding ribbon 10 is necessarily disposed obliquely with respect to the extension of the strip lines in relation to this portion 20.

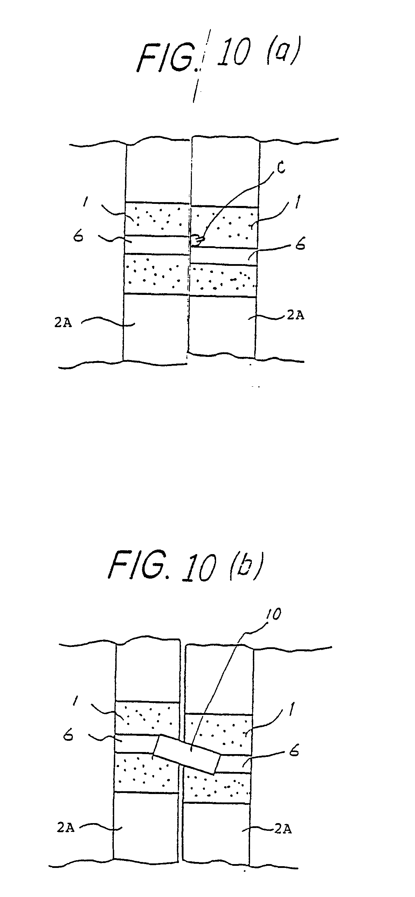

Figs. 10(a) and 10(b) are enlarged partial plan views respectively illustrating an exemplary positional mismatch between two abutting strip lines of previously proposed packages in cascade connection and an obliquely disposed bonding ribbon for interconnecting the mismatched abutting strip lines at the portion 20 in Fig. 8. In Figs. 10(a) and 10(b), like reference signs designate like or corresponding parts to those in the preceding Figures. The incorrectness in the relative positions of the strip lines is due to deviation of the electric terminal means from designed positions, which mainly occurs during processes for engaging and securing the electrical terminal means to the metallic container.

In the transmission of high-frequency signals between packages in cascade connection, a small step at the tips of interconnected abutting strip lines 6 works to provide a parasitic capacitance C as shown in Fig. 10(a). The capacitance is relative to the amount of the step (the value of the capacitance is related to the size of the step) and probably will be the cause of an impedance mismatch which will result in degradation of high frequency characteristics. This illustrates the primary significance of the positional accuracy required for the electrical terminal means.

The relatively-deviated abutting strip lines 6 must be connected to each other by an obliquely disposed bonding ribbon 10, so that no steps are produced there, as shown in Fig. 10(b). However, satisfaction of this requirement involves an elaborate and time-consuming procedure for bonding the ribbon 10, and the result is a low yield of products. Even when the bonding is successfully performed, the length of the bonding ribbon 10 is necessarily so large as to cause degradation of high-frequency characteristics as mentioned above. Quantitatively speaking, an increase in length corresponding to a tenth of a quarter wavelength of the high-frequency signal transmitted through the bonding ribbon 10 is assumed to have a significant effect. For instance, approximately O.30 mm for the frequency of 10 GHz.

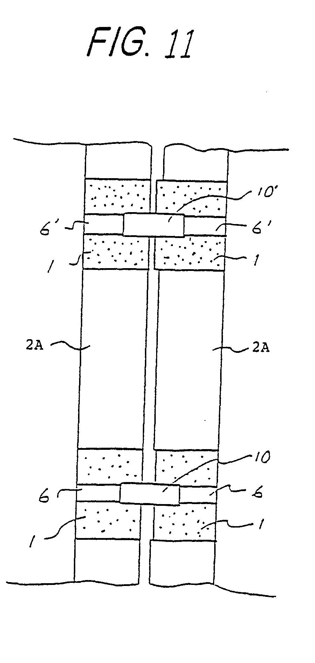

Another cause of increased length of a bonding ribbon is explained with reference to Fig. 11 which is a partial plan view illustrating corresponding abutting electrical terminal means of two neighbouring packages of the previously proposed design. In Fig. 11, like reference signs designate like or corresponding parts to those of preceding Figures. The conditions of engagement of the electrical terminal means 1 in corresponding through-holes in the metallic side wall portions 2A may differ. For example, there can arise a deeply engaging condition as illustrated on the lower side of Fig. 11 and a shallowly engaging condition as illustrated on the upper side of Fig. 11. As will be clearly understood from Fig. 11, if one of the engaging conditions as illustrated occurs in any one of the electrical terminal means 1 of two neighbouring packages, increase in length of bonding ribbons 10 between respective corresponding terminal means 1 on the packages is inevitably involved.

The aforesaid unfavourable increase in length of the bonding ribbons between the packages in cascade connection can be eliminated in an embodiment of the present invention because a plurality of strip lines formed on a single (unitary) electrical terminal means of a package are correctly arranged in parallel to each other with a predetermined pitch. That is, in the cascade connection of a plurality of such packages, if neighbouring packages are disposed so that a pair of corresponding strip lines of the packages abut each other, the remaining corresponding strip lines are made spontaneously (automatically) to abut each other without relative positional deviations. Thus, all the pairs of corresponding strip lines are interconnected with bonding ribbons having the same length, which may be a minimum length. The advantage of the single electrical terminal means structure afforded by an embodiment of the present invention in solving the problem explained with reference to Fig. 11 will be described below.

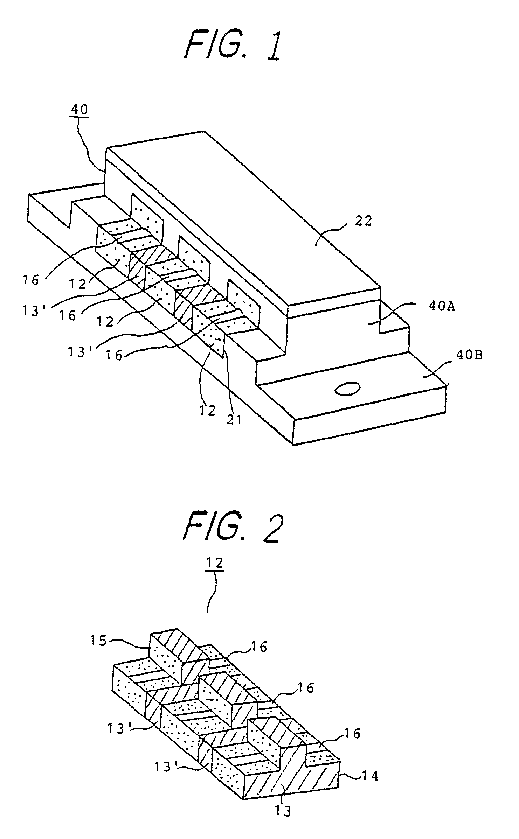

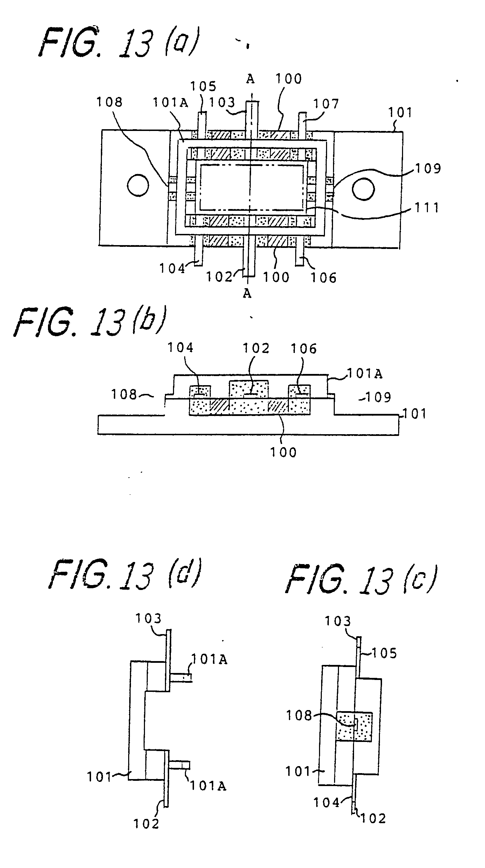

Fig. 1 is a perspective view illustrating a package, for a high-frequency semiconductor device, according to an embodiment of the present invention. Referring to Fig. 1, the package comprises a single electrical terminal means 12 and a metallic container 40 having a lid 22 attached thereon. The metallic container 40 has a metallic base portion 40B and a metallic side wall portion 40A, formed in a unified structure. The side wall portion 40A consists of two pairs of opposite side walls having a thickness, hence, providing a space for accommodating a semiconductor device or circuit therein. A through-hole 21 is formed in the side wall portion 40A. The single electrical terminal means 12 is engaged in the throughhole 21 and secured to the side wall portion 40A. In Fig. 2, 13' and 16 respectively designate a metallized layer and a strip line as explained below.

The electrical terminal means 12 has a structure as shown in the perspective view of Fig. 2. Referring to Fig. 2, the electrical terminal means 12 comprises an insulating material base 14 having a plurality of strip lines 16 formed thereon and a plurality of insulating material block members 15 covering the middle portions of corresponding strip lines 16. As will be clearly understood from Figs. 1 and 2, each of the insulating material block members 15 has a width (length) larger than that of a strip line 16 and length (width or thickness) substantially equal to the thickness of the side wall portion 40A.

The insulating material base 14 and block members 15 are combined together to form a unified body. A metallized layer 13 is formed to cover the respective opposite side surfaces of the insulating material base 14 and block members 15 and the respective upper surfaces of the latter. The bottom surface of the insulating material base 14 is also coated with the metallized layer. Further, belt-shaped metallized layers 13' are formed on the upper surface of the insulating material base 14 between the insulating material block members 15. The belt-shaped metallized layers 13' extend to selectively cover the other opposite side surfaces of the insulating material base 14. The metallized layers 13 and 13' are formed to have electrical connections (to be electrically connected to one another).

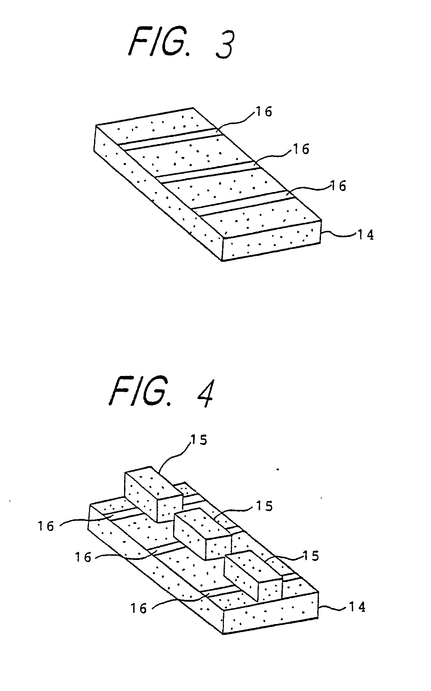

Figs. 3 and 4 are perspective views for explaining a fabrication process for making the electrical terminal means 12 shown in Fig. 2. As the raw material for the insulating material base 14, a green sheet of insulating material such as alumina is prepared using a conventional technique. That is, powder of alumina, for example, is kneaded with a binder composed of resin and solvent. The slurry of the alumina and the binder is formed into a sheet and then cut out into a predetermined size.

As shown in Fig. 3, on the surface of the green sheet of alumina, three parallel strip lines 16, each having a width of 0.3 mm, for example, are printed by using paste of a powdered metal such as tungsten (W) or molybdenum-manganese (Mo-Mn) alloy according to a conventional thick film technology. As the insulating material block members 15 of Fig. 2, three chips of the same green sheet are cut out to a predetermined size and placed on the green sheet for the insulating material base 14 so as to cover the middle portions of corresponding ones of the strip lines 16. Then the green sheet insulating material base 14 and green sheet block members 15 are sintered together with the metallic strip lines 16, and thus formed into a unified structure as shown in Fig. 4. Subsequently, metallized layers 13 and 13' as previously shown in Fig. 2 are selectively formed on the surfaces of the insulating material base 14 and block members 15.

Exemplary dimensions of the electrical terminal means 12 after sintering are 1.2 mm for the height from the bottom surface of the insulating material base 14 to the upper surface of each insulating material block member 15, 0.5 mm and 1 mm for the length of the insulating material block member 15 and the length of the insulating material base 14 in the direction along the extension of the strip lines 16 (the width of the block member and the width of the base 14), 0.3 mm and 1.2 mm for the respective widths of the strip lines 16 and the insulating material block member 15 (the length of the block member) and 4.6 mm for the length of the insulating material base 14 in the direction perpendicular to the extensions of the strip line 16. The spacing of the strip lines 16 is 1.7 mm, for example.

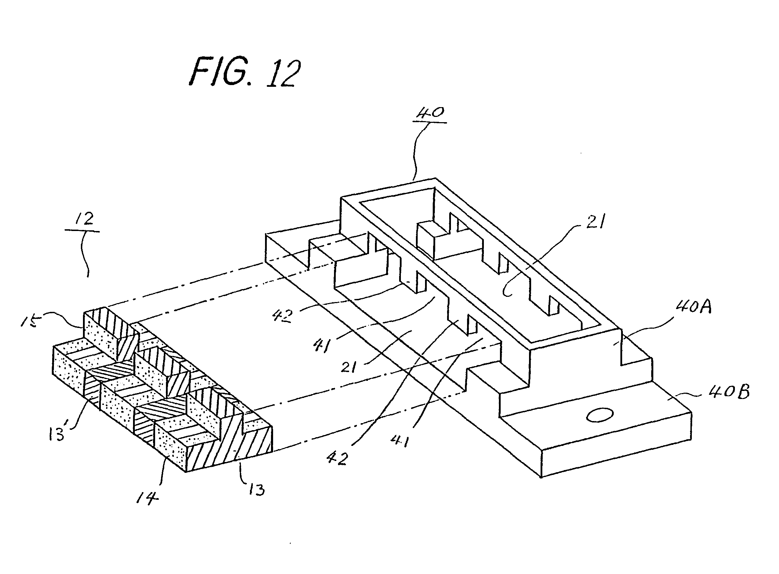

Fig. 12 is an exploded perspective view illustrating the assemblage of the metallic container 40 and electrical terminal means 12. As shown in Fig. 12, the throughhole 21 formed on the side wall portion 40A of container 40 has cutout portions 41 successively formed in an upper side edge thereof, leaving corresponding tooth portions 42 of the side wall portion 40A therebetween. The electrical terminal means 12 is inserted in the through-hole 21 so that each of the insulating material block members 15 is engaged in the corresponding one of the cutout portions 41. Accordingly, the bottom surface of the insulating material base 14 is disposed to face the metallic base portion 40B of the container 40. In the assembled condition, the insulating material base 14 and block members 15 are respectively brazed via the metallized layers 13 and 13' to the metallic base portion 40B and to the inner surfaces of the cutout portions 41, with a silver solder for example. Thus, hermetic sealing is afforded between the electrical terminal means 12 and the container 40.

Besides the advantage relating to avoidance of the problem of relative positional deviation of the separate electrical terminal means of the previously proposed package, the single electrical terminal means structure of the embodiment of the present invention package has a further advantage in alleviating the problem which arises from the occurrence of unfavourable engaging conditions as explained with reference to Fig. 11.

In the previously proposed package as shown in Fig. 5, if one of the three separately formed electrical terminal means is in a deep or a shallow engaging condition as explained above, the package must be rejected from use for cascade connection. With the package embodying the present invention, the occurrence of unfavourable engaging conditions can be minimized because fabrication process control is facilitated thanks to the larger-sized terminal means of the embodiment of the present invention compared with the previously proposed package. Also, faults due to angular deviation of the strip lines from designed perpendicularity with respect to the side wall can be minimized for the same reason. Accordingly, packages embodying the present invention can be provided substantially in accordance with predefined allowances.

In summary, the following advantages are provided by the packages according an embodiment of the present invention: (1) relative positional accuracy as between the strip lines of a package can be increased along with an increase in the accuracy of their positions on the package. Hence, the length of bonding ribbon between corresponding strip lines of packages in cascade connection can be minimized; (2) neighbouring strip lines on a package are electrically isolated from each other by a corresponding tooth portion 42 of the metallic side wall portion 40A and by the metallized layer 13' provided on the surface of the insulating material base 14 between the strip lines as shown in Fig. 12, therefore, high-frequency coupling between the strip lines can be prevented. As a result, semiconductor circuits housed in packages in cascade connection can operate with desired frequency characteristics.

In the above embodiment, the package comprises an electrical terminal means in which a plurality of strip line 16 are formed on a common insulating material base 14. However, another process for fabricating the electrical terminal means may be used instead (also for an embodiment of the invention) wherein the strip lines are formed on respective separate insulating material block members which are then disposed on a common insulating material base. Although this process requires more strict control with regard to the arrangement of the insulating block members on the base, positional accuracy with regard to the strip lines as mentioned above can still be high as compared with the previously proposed package. Further, in the above embodiment, the insulating material block members need not be limited to rectangular parallelepipeds, but can be of other types, for example members have a semicircular or trangular crosssection disposed on the insulating material base so that such crosssection is perpendicular to the extensions of the strip lines, provided the corresponding cutout portions on the side wall portion 40A are formed to fit the modified insulating material block members.

Figs. 13(a), 13(b) and 13(c) are respectively a plan view, a front view, a side view of a package according to another embodiment of the invention also applicable to cascade connection. Fig. 13(d) is a cross-section taken along line A-A in Fig. 13(a). The package shown in Fig. 13(a) comprises terminal means 100 for cascade connection and auxiliary terminal means 108 and 109. The terminal means 100 is fabricated according to the same procedure as explained with reference to Figs. 2 to 4 and secured to the metallic container 101 as shown in Fig. 12. The auxiliary terminal means 108 and 109 are fabricated according to the same procedure as the terminal means of the previously proposed package as explained with reference to Figs. 5 to 6, and then engaged in respective through-holes in the opposite side surfaces of the metallic container 101.

The strip lines 102 and 103 formed on the respective terminal means 100 are for transmitting high-frequency signals and the strip lines 104, 105, 106 and 107, which are also formed on the respective terminal means 100, are for supplying DC voltages. In Fig. 13(a), 111 is an internal circuit accommodated therein.

An exemplary usage of the auxiliary terminal means 108 and 109 is described in the following.

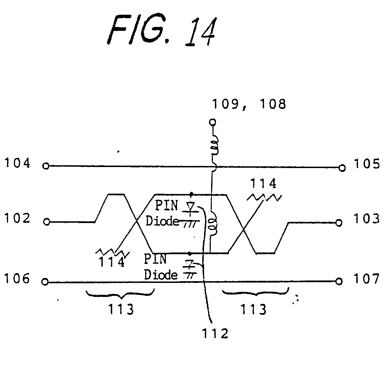

Fig. 14 is an equivalent circuit diagram of an attenuator comprising a PIN diode 112 (two PIN diodes 112 are shown) which is accommodated in the package of Fig. 13(a). The package containing the attenuator is connected to a package mounting an amplifier therein in cascade relationship as shown in Fig. 8, and operated as a variable gain control stage. The auxiliary terminal means 108 and 109 are used for controlling the loss of high-frequency signals transmitted through cascade connected strip lines 102 and 103 of the gain control stage, hence the gain of the amplifier stage can be changed.

For instance, when the gain must be kept constant with changing temperature conditions, a thermistor detects the temperature, and the attenuator increases loss as the gain of the amplifier increases as the temperature becomes lower. For an opposite temperature change, the attenuator decreases the loss. The change in loss is effected by controlling the bias voltage of the PIN diodes 112, which is supplied from the auxiliary terminal means 108 or 109.

The attenuator having the PIN diodes 112 is inserted in the transmission line in parallel relationship. When the PIN diodes 112 have a low resistivity, the impedance of the transmission line becomes low. When the resistivity becomes zero, the incoming high-frequency signals are reflected. On the other hand, when the resistivity of the PIN diodes 112 is increased, incoming signals are permitted to be transmitted to the output side. When the resistivity is further increased, reflection of signals occurs again. Thus, the input power is controlled to be output.

If there is large reflection of incoming signals, cascade connection of amplifier stages via the attenuator stage cannot operate. Therefore, a hybrid coupler 113 is provided for each of the input and output sides of the attenuator and reflected power is absorbed by terminal resistors 114. As a result, even when reflection of the incoming signals to the strip line 102 occurs in the attenuator, it does not appear on the strip line 103; hence, the output side of the attenuator is assumed to be terminated with a characteristic impedance of 50 ohm, and thus, the attenuator can be connected with the amplifier stages in a cascade relationship.

## Claims

1. A package for a semiconductor device, comprising:
a metallic container (40) for containing a semiconductor circuit, having a side wall (40a) with a through-hole (21) extending between the inside and the outside of the container;
electrical terminal means (12) engaged in said through-hole so as to be secured to said container, said electrical terminal means comprising:
an insulating material base (14) having a plurality of strip lines (16) formed thereon in parallel relationship and extending between the inside and the outside of the container; and
a plurality of insulating material block members (15) each of said insulating material block members being disposed on said insulating material base so as to selectively cover a corresponding one of said strip lines at a middle portion of the line.

2. A package for a semiconductor device, comprising:
a metallic container (40) for containing a semiconductor circuit, including a metallic base portion (40B) and a metallic side wall portion, (40A) said side wall portion having a through-hole (21) provided with cutout portions (41) successively formed on an edge thereof to leave corresponding tooth portions (42) of said side wall portion therebetween; and
a unitary (single) electrical terminal means engaged in said through-hole and secured to said container, said electrical terminal means including;
an insulating material base portion (14) having a plurality of strip lines (16) formed thereon in parallel relationship penetrating said side wall portion perpendicularly, each of said strip lines having a width in a direction perpendicularly transverse to said strip lines, said insulating material base having a surface bonded to said metallic base portion; and
a plurality of insulating material block members (15) having a width larger than the width of said strip lines and a depth substantially equal to the thickness of said side wall, each of said insulating material block members being secured to said insulating material base so as to selectively cover a corresponding one of said strip lines with a surface thereof defined by the width and depth, each of said insulating material block means having a surface bonded to corresponding one of said cutout portions.

3. A package as claimed in claim 2, wherein said insulating material base (14) has a substantially rectangular cross-section in a plane perpendicular to the direction in which said strip lines extend.

4. A package as claimed in claim 2 or 3, wherein each of said insulating material block (15) members has a substantially rectangular cross-section in a plane perpendicular to the direction in which said strip lines extend.

5. A package as claimed in claim 2, 3 or 4, wherein said tooth portions (42) are formed to extend to said insulating material base (14).

6. A package as claimed in claim 2, 3, 4 or 5, wherein each of said tooth portions (42) is bonded to said insulating material base (14) at a tip thereof, along a length of the tip.

7. A package as claimed in claim 2, 3, 4, 5 or 6, further comprising metallized layers (13') formed on said insulating material base so as to connect said tips of said tooth portions (42) to said base plate portion of said container.

8. A package as claimed in claim 2, 3, 4, 5, 6 or 7, further comprising a lid (22) secured to said container.

9. A package as claimed in claim 2, 3, 4, 5, 6, 7 or 8, wherein said container (40) is formed of copper.

10. A package as claimed in claim 2, 3, 4, 5, 6, 7, 8 or 9, wherein said insulating material base (14) and said insulating material block members (15) are composed of alumina.

11. A package as claimed in claim 2, said electrical terminal means (12) being hermetically sealed to said container (40).

12. A package as claimed in claim 11, said electrical terminal means (12) being brazed to said container (40).

13. A package as claimed in any previous claim, wherein said insulating material base (14) comprises a common insulating material base portion on which respective separate insulating material blocks are disposed, on which blocks respective strip lines are formed.

## Patentansprüche

1. Packung für eine Halbeitervorrichtung mit:
einem metallischen Behälter (40) zur Aufnahme einer Halbleiterschaltung, mit einer Seitenwand (40a) mit einem Durchgangsloch (21), welches sich von der Innenseite zu der Außenseite des Behälters erstreckt;
elektrischen Anschlußeinrichtungen (12), die mit dem genannten Durchgangsloch so zum Eingriff kommen, daß sie an dem genannten Behälter gesichert sind, welche elektrische Anschlußeinrichtungen umfassen:
eine isolierende Materialbasis (14), die eine Vielzahl von Streifenleitungen (16) hat, die darauf in paralleler Relation angeordnet sind und sich zwischen der Innenseite und der Außenseite des Behälters erstrecken; und eine Vielzahl von Blockteilen (15) aus isolierendem Material, von denen jedes Blockteil aus isolierendem Material auf der isolierenden Materialbasis so angeordnet ist, daß es selektiv eine entsprechende der Streifenleitungen an einem mittleren Abschnitt der Leitung bedeckt.

2. Packung für eine Halbleitervorrichtung mit:

einem metallischen Behälter (40) zur Aufnahme einer Halbleiterschaltung, mit einem metallischen Basisabschnitt (40B) und einem metallischen Seitenwandabschnitt (40a), welcher genannte Seitenwandabschnitt ein Durchgangsloch (21) aufweist, das mit ausgeschnittenen Abschnitten (41) versehen ist, die sukzessive an einem Rand desselben gebildet sind, um entsprechende Zahnabschnitte (42) des Seitenwandabschnitts dazwischen zu lassen; und

einer einheitlichen (einzigen) elektrischen Anschlußeinrichtung, die mit dem genannten Durchgangsloch zum Eingriff kommt und an dem genannten Behälter befestigt ist, welche genannte elektrische Anschlußeinrichtung umfaßt:

einen isolierenden Materialbasisabschnitt (14), der eine Vielzahl von Streifenleitungen (16) hat, die darauf in paralleler Relation angeordnet sind und den genannten Seitenwandabschnitt senkrecht durchdringen, wobei jede der genannten Streifenleitungen eine Breite in einer Richtung senkrecht quer zu den genannten Streifenleitungen hat, die isolierende Materialbasis eine Oberfläche hat, die mit dem genannten Metallbasisabschnitt verbunden ist; und

eine Vielzahl von Blockteilen (15) aus isolierendem Material, die eine Breite haben, die größer als die Breite der genannten Streifenleitungen ist, und eine Tiefe, die im wesentlichen gleich der Dicke der genannten Seitenwand ist, wobei jedes der Blockteile aus isolierendem Material an der genannten isolierenden Materialbasis so befestigt ist, daß es selektiv eine entsprechende der genannten Streifenleitungen bedeckt, mit einer Oberfläche davon begrenzt durch die Breite und Tiefe, und jede der genannten Blockeinrichtungen aus isolierendem Material eine Oberfläche hat, die mit einer entsprechenden der genannten ausgenommenen Abschnitte verbunden ist.

3. Packung nach Anspruch 2, bei der die genannte isolierende Materialbasis (14) einen im wesentlichen rechtwinkligen Querschnitt in einer Ebene senkrecht zu der Richtung hat, in der die genannten Streifenleitungen sich erstrecken.

4. Packung nach Anspruch 2 oder 3, bei der jedes der genannten Blockteile (15) aus isolierendem Material (15) einen im wesentlichen rechtwinkligen Querschnitt in einer Ebene hat, die senkrecht zu der Richtung ist, in welcher sich die genannten Streifenleitungen erstrecken.

5. Packung nach Anspruch 2, 3 oder 4, bei der die genannten Zahnabschnitte (42) so gebildet sind, daß sie sich zu der genannten isolierenden Materialbasis (14) erstrecken.

6. Packung nach Anspruch 2, 3, 4 oder 5, bei der jeder der genannten Zahnabschnitte (42) mit der genannten isolierenden Materialbasis (14) an einer Spitze derselben, längs einer Länge der Spitze, verbunden ist.

7. Packung nach Anspruch 2, 3, 4, 5 oder 6, ferner mit metallisierten Schichten (13'), die auf der genannten isolierenden Materialbasis so gebildet sind, daß sie die genannten Spitzen von den genannten Zahnabschnitten (42) mit dem genannten Basisplattenabschnitt von dem genannten Behälter verbinden.

8. Packung nach Anspruch 2, 3, 4, 5, 6 oder 7, ferner mit einem Deckel (22), die an dem genannten Behälter befestigt ist.

9. Packung nach Anspruch 2, 3, 4, 5, 6, 7 oder 8, bei der der genannte Behälter (40) aus Kupfer geformt ist.

10. Packung nach Anspruch 2, 3, 4, 5, 6, 7, 8 oder 9, bei der die genannte isolierende Materialbasis (14) und die genannten Blockteile (15) aus isolierendem Material aus Tonerde bestehen.

11. Packung nach Anspruch 2, bei der die elektrischen Anschlußeinrichtungen (12) hermetisch mit dem genannten Behälter (40) versiegelt sind.

12. Packung nach Anspruch 11, bei der die genannten elektrischen Anschlußeinrichtungen an den genannten Behälter (14) angelötet sind.

13. Packung nach einem der vorhergehenden Anschlüsse, bei der die genannte isolierende Materialbasis (14) einen gemeinsamen isolierenden Materialbasisabschnitt umfaßt, auf dem entsprechende separat isolierende Materialblöcke angeordnet sind, auf welchen Blöcken jeweils Streifenleitungen gebildet sind.

**Revendications**

1. Boîtier pour dispositif à semi-conducteur, comprenant

un récipient métallique (40) destiné à contenir un circuit à semi-conducteur et ayant une paroi latérale (40A) dans laquelle est formé un trou débouchant (21) disposé entre l'intérieur et l'extérieur du récipient, et

un dispositif (12) à bornes électriques placé dans le trou afin qu'il soit fixé au récipient, le dispositif à bornes électriques comprenant;

une base (14) d'un matériau isolant, ayant plusieurs lignes plates (16) formées sur elle en directions parallèles et disposées entre l'intérieur et l'extérieur du récipient, et

plusieurs blocs (15) d'un matériau isolant, chacun des blocs étant disposé sur la base du matériau isolant afin qu'il recouvre une ligne plate correspondante au niveau de la partie médiane de la ligne.

2. Boîtier pour dispositif à semi-conducteur, comprenant

un récipient métallique (40) destiné à contenir un circuit à semi-conducteur, comprenant une partie métallique de base (40B) et une partie métallique (40A) de paroi latérale, la partie de paroi latérale ayant un trou débouchant (21) formé avec des découpes (41) disposées successivement à un bord de manière qu'il reste des parties correspondantes de dent (42) formées par la partie de paroi latérale entre les découpes, et un dispositif unitaire (en une seule pièce) à bornes électriques disposé dans le trou débouchant et fixé au récipient, le dispositif à bornes électriques comprenant

une partie de base (14) formée d'un matériau isolant et ayant plusieurs lignes plates (16) formées sur elle, ces lignes pénétrant parallèlement dans la partie de paroi latérale en direction perpendiculaire à celle-ci, chacune des lignes plates ayant une largeur mesurée en direction perpendiculaire à la longueur des lignes plates, la base d'un matériau isolant ayant une surface fixée à la partie métallique de base, et

plusieurs blocs (15) d'un matériau isolant, ayant une largeur supérieure à la largeur des lignes plates et une profondeur sensiblement égale à l'épaisseur de la paroi latérale, chacun des blocs d'un matériau isolant étant fixé à la base d'un matériau isolant de manière qu'il recouvre sélectivement une ligne plate correspondante par une surface ayant lesdites largeur et profondeur, chacun des blocs d'un matériau isolant ayant une surface fixée à une partie découpée correspondante.

3. Boîtier selon la revendication 2, dans lequel la base (14) d'un matériau isolant a une section pratiquement rectangulaire dans un plan perpendiculaire à la direction de la longueur des lignes plates.

4. Boîtier selon la revendication 2 ou 3, dans lequel chacun des blocs (15) d'un matériau isolant a une section sensiblement rectangulaire dans un plan perpendiculaire à la direction de la longueur des lignes plates.

5. Boîtier selon la revendication 2, 3 ou 4. dans lequel les parties en forme de dent (42) sont disposées afin qu'elles parviennent jusqu'à la base (14) d'un matériau isolant.

6. Boîtier selon la revendication 2, 3, 4 ou 5, dans lequel chacune des parties en forme de dent (42) est liée à la base (14) d'un matériau isolant par son extrémité, suivant la longueur de cette extrémité.

7. Boîtier selon la revendication 2, 3, 4, 5 ou 6, comprenant en outre des couches métallisées (13') formées sur la base d'un matériau isolant afin qu'elles relient les extrémités des parties de dent (42) à la partie plate de base du récipient.

8. Boîtier selon la revendication 2, 3, 4, 5, 6 ou 7, comprenant en outre un couvercle (22) fixé au récipient.

9. Boîtier selon la revendication 2, 3, 4, 5, 6, 7 ou 8, dans lequel le récipient (40) est formé de cuivre.

10. Boîtier selon la revendication 2, 3, 4, 5, 6, 7, 8 ou 9, dans lequel la base (14) d'un matériau isolant et les blocs (15) d'un matériau isolant sont formés d'alumine.

11. Boîtier selon la revendication 2, dans lequel le dispositif (12) à bornes électriques est scellé hermétiquement sur le récipient (40).

12. Boîtier selon la revendication 11, dans lequel le dispositif (12) à bornes électriques est brasé sur le récipient (40).

13. Boîtier selon l'une quelconque des revendications précédentes, dans lequel la base (14) d'un matériau isolant comporte une partie commune de base d'un matériau isolant sur laquelle sont disposés des blocs séparés d'un matériau isolant, les lignes plates respectives étant formées sur les blocs.

# FIG. 1

# FIG. 2

## FIG. 3

## FIG. 4

# FIG. 5

# FIG. 6

# FIG. 7

## FIG. 8

## FIG. 9

## FIG. 10 (a)

## FIG. 10 (b)

# FIG. 11

FIG. 12

FIG. 13 (a)

FIG. 13 (b)

FIG. 13 (d)

FIG. 13 (c)

EP 0 177 943 B1

# FIG. 14